# EUROPÄISCHE PATENTSCHRIFT

(11) **EP 0 777 879 B1**
(45) Veröffentlichungstag und Bekanntmachung des Hinweises auf die Patenterteilung: **21.07.1999**
(21) Anmeldenummer: 95927631.2
(22) Anmeldetag: 04.08.1995
(51) Int. Cl.: G06F 11/20, H04L 1/22

(54) **ERSATZSCHALTUNG FÜR MEHRERE FUNKTIONSEINHEITEN**
EQUIVALENT CIRCUIT FOR SEVERAL FUNCTIONAL UNITS
CIRCUIT EQUIVALENT POUR PLUSIEURS UNITES FONCTIONNELLES

(30) Priorität: 31.08.1994 DE 4431021
(43) Veröffentlichungstag der Anmeldung: 11.06.1997
(73) Patentinhaber: SIEMENS AKTIENGESELLSCHAFT, 80333 München (DE)
(72) Erfinder: SCHALAMON, Friedrich, D-82110 Germering (DE); IKI, Kunihiko, D-82256 Fürstenfeldbruck (DE)
(86) Internationale Anmeldenummer: DE9501024
(87) Internationale Veröffentlichungsnummer: WO9607138

(56) Entgegenhaltungen:
- EP-A- 0 496 999
- EP-A- 0 507 379
- DE-A- 4 132 598
- US-A- 3 937 936
- US-A- 4 082 964
- PATENT ABSTRACTS OF JAPAN vol. 8, no. 101 (P-273) 12. Mai 1984 & JP,A,59 011 454 (MITSUBISHI DENKI) 21. Januar 1984
- IBM TECHNICAL DISCLOSURE BULLETIN, Bd.18, Nr.6, November 1975 Seiten 1691 - 1692 BRADY ET AL 'automatic duplexing for data processors'

## Beschreibung

Die Erfindung betrifft eine Ersatzschaltung für mehrere Funktionseinheiten.

Es ist bekannt, zur Erhöhung der Betriebssicherheit Ersatzschaltungen vorzusehen. Fällt eine Funktionseinheit, beispielsweise eine Baugruppe, aus, wird diese aus dem Signalweg (oder den Signalwegen) herausgetrennt und eine Ersatz-Funktionseinheit wird an ihrer Stelle eingeschaltet. Zur Umschaltung wurden Relais verwendet; bei digitalen Signalen ist auch eine Realisation der Umschaltung durch Logikbausteine möglich.

Aus der Offenlegungsschrift DE 41 32 598 A1 ist ein System zur Umschaltung von Geräten der Nachrichtentechnik bekannt, bei dem zum Zwecke des Ersatzes oder der Prüfung eines dieser Geräte auf ein Ersatzgerät umgeschaltet wird. Zur Umschaltung werden Relais verwendet.

Auch im Patentabstrakt des Patents JP-A-59 011 454 ist eine Ersatzschaltung dargestellt, die über mechanische Schalter eingeschaltet wird.

Die Verwendung von Relais zur Umschaltung von Betriebs-Funktionseinheiten und Ersatz-Funktionseinheiten ist äußerst problematisch. Die Zuverlässigkeit der Relais nimmt bei den äußerst selten durchgeführten Umschaltungen rapide ab.

Bei einer Ersatzschaltung, die digitale oder analoge Signale mit höheren Frequenzen von ca. 30 Megahertz (MHz) oder sogar von einigen Gigahertz verarbeitet, ergeben sich weitere Probleme.

Die Relais-Kontakte weisen zu hohe Kapazitäten auf, so daß bereits aus diesem Grunde eine Verwendung nicht in Frage kommt. Außerdem würde diese Lösung die Bereitstellung einer größeren Leistung erforderlich machen.

Aus der deutschen Auslegeschrift 26 08 117 sind Diodenschalter bekannt, die für Umschaltzwecke im Hochfrequenzbereich besser geeignet sind.

Aus der Offenlegungsschrift DE 41 02 930 A1 ist eine Schaltung zum Aufteilen oder Zusammenführen von Hochfrequenzleistung bekannt, bei der zum Aufteilen von einem Summentor zugeführter Hochfrequenzleistung auf mehrere Einzeltore bzw. zum Zusammenführen von Einzeltoren zugeführter Hochfrequenzleistung in einen Summentor der zwischen den Einzeltoren jeweils wirkende Erstauslaßwiderstand durch einen einseitig an Masse geschalteten Absorberwiderstand gebildet wird. Bei dieser Anordnung ist jedoch nur eine geringe Entkopplung zwischen den Eingängen bzw. den Ausgängen gegeben.

Aufgabe der Erfindung ist es, eine für höhere Frequenzen geeignete Ersatzschaltung für mehrere Funktionseinheiten anzugeben. Diese Aufgabe wird durch eine Ersatzschaltung nach Anspruch 1 gelöst.

Vorteilhafte Weiterbildungen der Erfindung sind in den Unteransprüchen angegeben.

Die Verwendung von jeweils nur einer Ersatz-Funktionseinheit für mehrere Betriebs-Funktionseinheiten ist besonders vorteilhaft. Bei der hohen Ausfallsicherheit ist eine Doppelung von Systemen oder Funktionseinheiten meist nicht mehr erforderlich. Als besonders einfache, preiswerte und vorteilhafte Variante können Kombinierer und Verteiler mit PIN-Dioden ausgeführt werden. Diese weisen mit Hilfe von Entkopplungswiderständen und wegen der Beschränkung auf jeweils zwei Ein- oder Ausgänge eine besonders hohe Dämpfung auf.

Auch als elektronische Umschalter sind PIN-Dioden-Kombinationen vorgesehen. Die Dämpfung der Schalter wird durch gegen Masse geschaltete PIN-Dioden optimal.

Es ist zweckmäßig, die PIN-Dioden-Umschalter auf den Baugruppen der Funktionseinheiten unterzubringen.

Jede Funktionseinheit (Baugruppe) enthält zweckmäßigerweise zur Überwachung, Steuerung und Signalisierung einen sogenannten Einschubrechner. Seine Daten und die Daten weiterer Funktionseinheiten werden einer zweckmäßigerweise auf der Kombinationsbaugruppe befindlichen Logikschaltung zugeführt, die im Fehlerfall die defekten Funktionseinheiten abtrennt und die Ersatz-Funktionseinheit einfügt.

Für eine weiter erhöhte Zuverlässigkeit können auch mehrere Ersatz-Funktionseinheiten vorgesehen werden, die über eine separate Kombinationsschaltung jeweils mit der zugehörigen Ersatz-Funktionseinheiten verbunden sind.

Ein Ausführungsbeispiel der Erfindung wird anhand von Figuren näher beschrieben. Es zeigen:
- Figur 1: ein Blockschaltbild der Erfindung,
- Figur 2: eine Ersatzschaltung mit mehreren Ersatz-Funktionseinheiten,
- Figur 3: eine vorteilhafte Ansteuerung eines PIN-Dioden-Umschalters,
- Figur 4: eine weitere Ansteuerungsmöglichkeit eines PIN-Dioden-Umschalters und
- Figur 5: ein Prinzipschaltbild eines Kombinierers,
- Figur 6: ein Prinzipschaltbild eines Verteilers,
- Figur 7: ein Ausführungsbeispiel eines Zweifach-Kombinierers und
- Figur 9: ein Ausführungsbeispiel eines Zweifach-Verteilers.

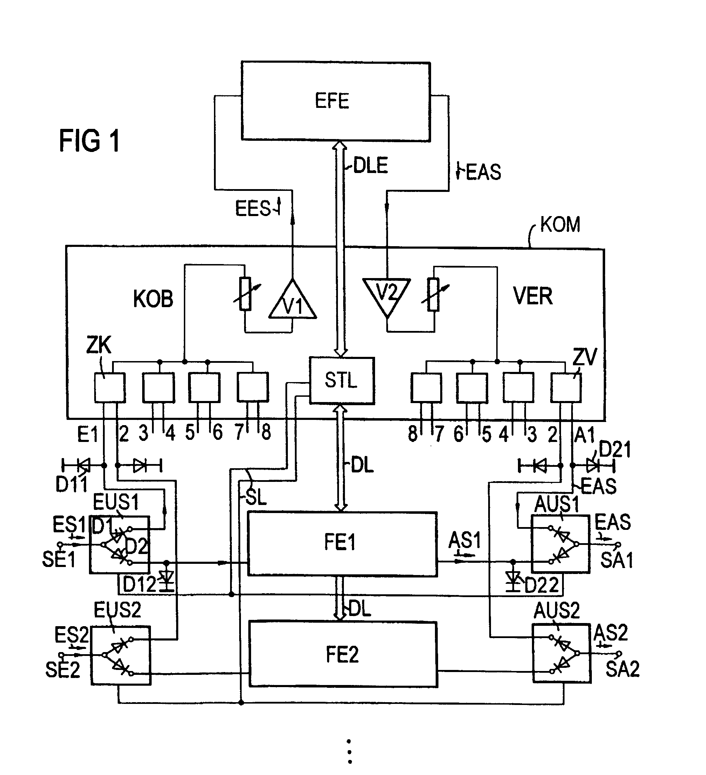

Figur 1 zeigt das Prinzip der erfindungsgemäßen Ersatzschaltung. Mehreren gleichen Funktionseinheiten FE1, FE2, ... ist eine Ersatz-Funktionseinheit EFE zugeordnet. In dem Prinzipschaltbild wird davon ausgegangen, daß jeweils nur ein digitales Eingangssignal ES1, ES2... und ein Ausgangssignal AS1, AS2... je Funktionseinheit vorhanden ist. Jeder Funktionseinheit wird ihr Eingangssignal ES1, ES2, .. über einen Signaleingang SE1, SE2, ...eines Eingangsumschalter EUS1, EUS2, .. zugeführt, während das Ausgangssignal AS1, AS2, ... über einen Ausgangsumschalter AUS1, AUS2, ... an einem Signalausgang SA1, SA2, ... abgegeben wird. Werden einer Funktionseinheit mehrere Eingangssignale zugeführt und/oder werden mehrere Ausgangssignale abgegeben, dann werden diese Signale über weiter Umschalter geführt.

Jeweils der zweite Ausgang jedes Eingangsumschalters EUS1, EUS2,.. wird an einen Eingang E1, E2, ... einer Kombinationseinheit KOM geführt. Entsprechend sind Ausgänge A1, A2, ... der Kombinationseinheit an zweite Eingänge der Ausgangsumschalter AUS1, AUS2, ... geführt. Die Funktionseinheiten sind über Datenleitungen DL - hier einem Bussystem - mit einer auf der Kombinationseinheit KOM angeordneten Steuerlogik STL verbunden.

Auf der Kombinationseinheit KOM ist ein Kombinierer KOB, der aus Zweifach-Verteilern ZV, und ein Verteiler VER, der aus Zweifach-Kombinierern ZK aufgebaut ist, dargestellt. Jeweils eines von acht möglichen Eingangssignalen wird an einen ersten Verstärker V1 durchgeschaltet, der dieses Signal auf den ursprünglichen Eingangspegel verstärkt und als Ersatz-Eingangssignal EES an eine Ersatz-Funktionseinheit EFE weitergibt. Das Ersatz-Ausgangssignal EAS wird über einen zweiten Verstärker V2 und den Kombinierer VK2 auf (hier) auf einen von acht Ausgängen durchgeschaltet. Das Ersatzsignal wird einem zweiten Eingang eines der Ausgangsumschalter AUS1, AUS2, ... zugeführt.

Die elektronischen Umschalter sind als PIN-Dioden-Umschalter ausgeführt und weisen zwei mit ihren gleichen Anschlüssen zusammengeschaltete Längsdioden D1 und D2 auf.

Bei den Eingangsumschaltern ist zumindest an einem ihrer Ausgänge jeweils eine weitere Querdiode D11 oder D12 vorgesehen, die zur Dämpfungserhöhung durchlässig geschaltet wird, wenn der jeweilige Schalterausgang nicht aktiv ist. Für die Ausgangsumschalter können dieselben Umschalter verwendet werden.

Über Datenleitungen DLE ist auch die Ersatz-Funktionseinheit EFE mit der Logikschaltung LS verbunden. Über diese Datenleitungen kann auch die Funktion der Ersatz-Funktionseinheit überwacht werden.

Wenn beispielsweise die Überwachung der ersten Funktionseinheit FE1 einen Defekt feststellt, so wird dieser über die Datenleitungen DL der Steuerlogik STL gemeldet. Diese schaltet über Steuerleitungen LS das erste Eingangssignal ES1 auf den zweiten Ausgang des ersten Eingangsumschalters EUS1 und damit an den ersten Eingang El der Kombinationseinheit KOM durch. An sämtliche anderen Eingängen E2 bis E8 des Kombinierers KOB liegt kein Signal an. Das Eingangssignal ES1 gelangt zum Verstärker V1, wird dort auf den ursprünglichen Pegel verstärkt und als Ersatz-Eingangssignal EES der Ersatz-Funktionseinheit EFE zugeführt. Diese erzeugt ein entsprechendes Ersatz-Ausgangssignal EAS, dessen Pegel (gegebenenfalls) durch den zweiten Verstärker V2 erhöht wird, und gibt dieses an sämtlichen Ausgängen A1 bis A8 des zweiten Verteiler VER ab.

Nur der erste Ausgangsumschalter AUS1 schaltet jedoch das Ersatzausgangssignal EAS an seinen Signalausgang A1 durch.

Die Logikschaltung signalisiert außerdem, welche Funktionseinheit ausgefallen ist. Die defekte Funktionseinheit FE1 kann entnommen und durch eine intakte Funktionseinheit ersetzt werden.

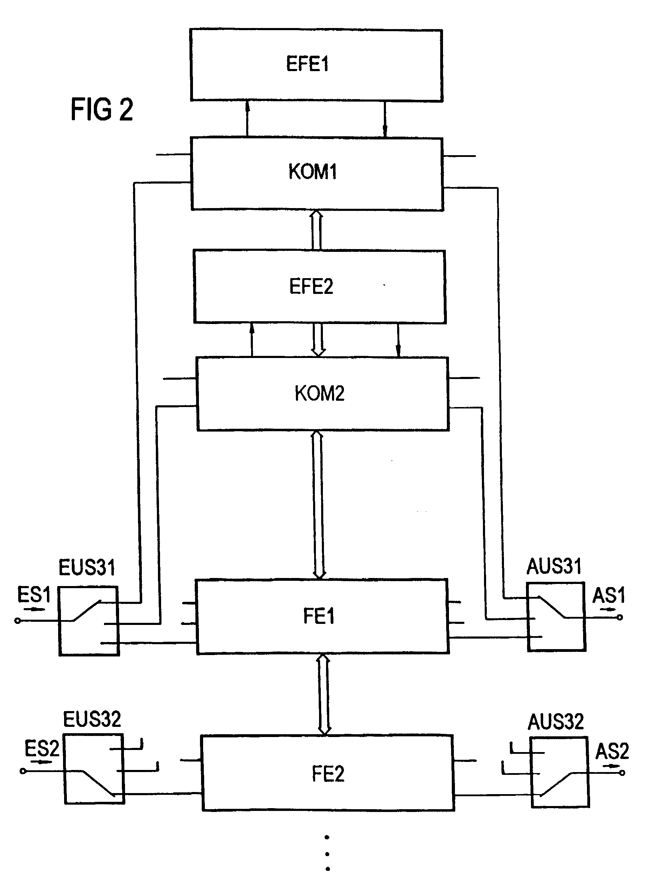

In Figur 2 ist ein Blockschaltbild mit zwei Kombinationseinheiten KOM1 und KOM2 sowie zwei Ersatz-Funktionseinheiten EFE1 und EFE2 dargestellt. Es werden Eingangsumschalter EUS31 und EUS32 mit jeweils drei Ausgängen verwendet, von denen jeweils einer mit der Funktionseinheit FE1 bzw. FE2 verbunden ist und die anderen mit jeweils einer Kombinationseinrichtung KOM1 oder KOM2 verbunden sind. Auch sind entsprechend ausgeführte Ausgangsumschalter AUS31, AUS32, ... mit jeweils drei Eingängen vorgesehen. Über nicht dargestellte Datenleitungen kann jetzt anstelle jeder beliebigen Funktionseinheit eine Ersatzfunktionseinheit ausgewählt werden. Durch diese Schaltungsanordnung kann der Betrieb aufrecht erhalten werden, wenn insgesamt zwei Funktionseinheiten FE1, FE2, ... bzw. eine der Ersatz-Funktionseinheiten EFE1 oder EFE2 ausfallen.

Selbstverständliche können auch mehr als zwei Ersatz-Funktionseinheiten vorgesehen werden oder - je nach Zuverlässigkeit - Mischformen realisiert werden.

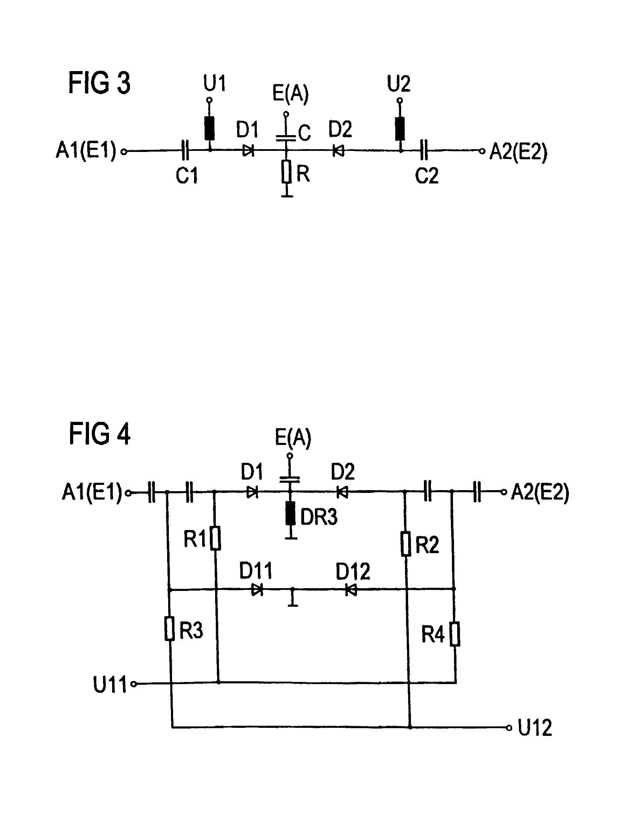

Figur 3 zeigt eine besonders vorteilhafte Ansteuerung für die PIN-Diodenumschalter. Zwei Längsdioden D1 und D2 sind mit gleichen Anschlüssen zusammengeschaltet, die den Eingang eines Eingangsumschalters oder den Ausgang eines Ausgangsumschalters bilden. Eingänge E, (E1, E2) und Ausgänge A1, A2, (A) sind durch Kondensatoren C, C1, C2 gleichspannungsmäßig entkoppelt. Durch eine über eine Drossel DR1 angelegte Betriebsspannung U1 (ca. +3 bis +5 V) ist die Diode D1 über den Widerstand R durchgeschaltet, während die andere Diode D2 durch eine Steuerspannung U2 = 0 V gesperrt ist. Wird die Steuerspannung U2 auf +10 V erhöht, so wird die Diode D2 durchgeschaltet, jedoch die Diode D1 gesperrt, da an ihrer Kathode nunmehr ca. +9 V anliegen. Durch die Steuerspannung U2 kann gleichzeitig eine am Eingang E1 (Ausgang A1) angeschaltete Querdiode nach Masse durchgeschaltet werden. Bei dieser vorteilhaften Anordnung wird nur eine Steuerspannung 0Volt/U2 und nur eine Steuerleitung benötigt.

Figur 4 zeigt einen PIN-Dioden-Umschalter, der Querdioden D11 und D12 aufweist. Durch eine positive Steuerspannung U11 werden die Dioden D1 und D12 leitend geschaltet, während die Dioden D2 und D11 durch eine Steuerspannung U2 gesperrt werden.

Die Zuführung der Steuerspannung an die Längsdioden D1 und D2 erfolgt über Widerstände R1 und R2. Der gemeinsame Verbindungspunkt ist über eine Drossel DR3 an Masse geführt. Diese Schaltung benötigt nur eine Drossel DR3. Anstelle der Widerstände R1 und R2 bzw. R3 und R4 können natürlich ebenfalls Drosseln verwendet werden.

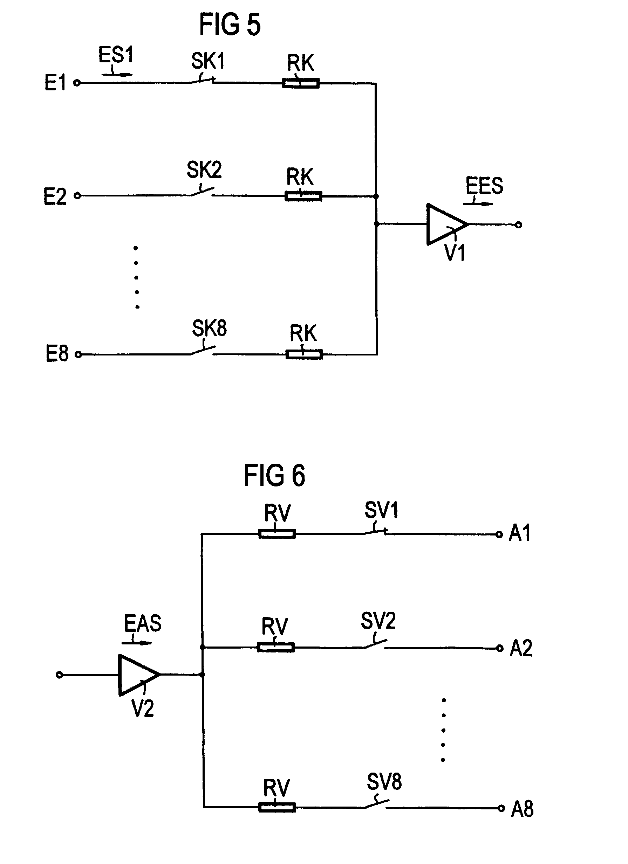

In Figur 5 ist das Prinzipschaltbild des Kombinierers KOB dargestellt. Dieser ist mit elektronischen Schaltern SK1, SK2, ... aufgebaut, deren Eingängen E1, E2, ... die Eingangssignale ES1, ES2 ...zugeführt werden, von denen jeweils eines über einen einzigen geschlossenen elektronischen Schalter als Ersatz-Eingangssignal EES über einen zugeordneten Entkopplungswiderstand RK an einen gemeinsamen Verbindungspunkt und - meist über einen Verstärker V1 - zur Ersatz-Funktionseinheit durchgeschaltet wird.

In Figur 6 ist das Prinzipschaltbild eines entsprechenden Verteilers VER dargestellt, bei dem das Ersatzausgangssignal EAS - meist über einen Verstärker V2 - von einem Verzweigungspunkt über jeweils einen Entkopplungswiderstand RV und einen der elektronischen Schalter SV1, SV2, ... auf einen der Ausgänge A1, A2, ... durchgeschaltet wird.

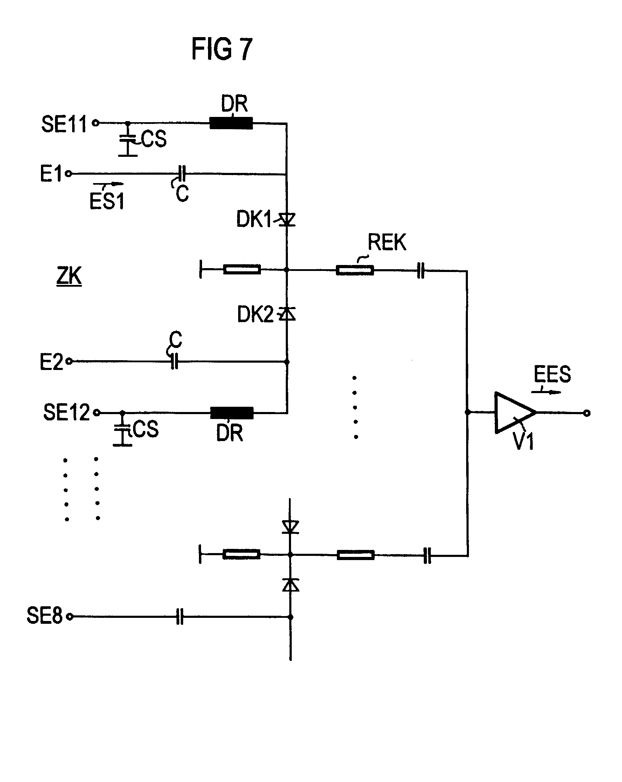

In Figur 7 ist eine vorteilhafte Ausführung des Kombinierers dargestellt, bei dem jeweils Zweifachkombinierer ZK aus zwei PIN-Dioden DK1, DK2 aufgebaut sind, die mit ihren gleichen Elektroden zusammengeschaltet sind. Ihr anderer Anschluß ist jeweils über einen Koppelkondensator C auf einen Eingang E1, E2, ... geführt. Da sie im Signalweg liegen , werden sie als Längsdioden bezeichnet. Über eine Drossel DR und einen Siebkondensator CS kann eine der Dioden über Steuereingänge SE11, SE12, ... leitend geschaltet werden. Dann wird das durchgeschaltete Eingangssignal ES1 vom Verbindungspunkt der PIN-Dioden über einen gemeinsamen Entkopplungswiderstand REK zum Eingang des Verstärkers V1 geführt, an dem in der Regel noch weitere gleich aufgebaute Schalterpaare angeschlosssen sind.

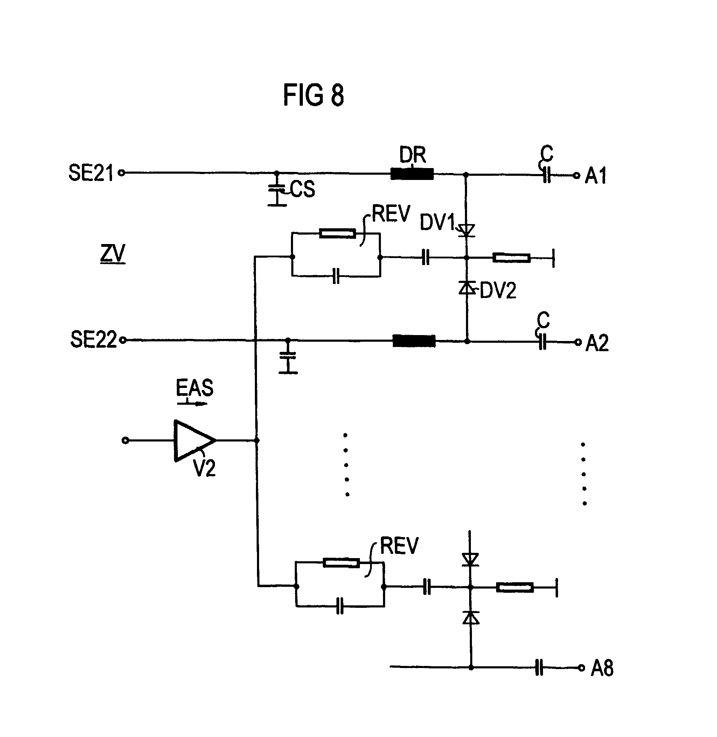

In Figur 8 zeigt einen Verteiler mit im wesentlichen den Zweifachkombinierern entsprechenden Zweifachverteilern. Der Ausgang des zweiten Verstärkers V2 ist über jeweils einen weiteren Entkopplungswiderstand REV an ein PIN-Diodenpaar geführt, dessen gleiche Elektrodenanschlüsse zusammengeschaltet sind, während die anderen Diodenanschlüsse jeweils über Koppelkondensatoren C auf einen Ausgang A1, A2, ... geführt sind, auf den das Ersatzausgangssignal EAS durchgeschaltet wird. Jeweils eine PIN-Diode wird über eine Drossel und Siebkondensator bestehende Siebschaltung durch an Steuereingängen SE21, SE22, ... anliegende Steuerspannungen durchgeschaltet.

## Patentansprüche

1. Ersatzschaltung für mehrere Funktionseinheiten (FE1, FE2,...), bei der
mehreren gleichen Funktionseinheiten (FE1, FE2, ...) mindestens eine Kombinationseinheit (KOM) und eine daran angeschaltete Ersatz-Funktionseinheit (EFE) zugeordnet ist,
jeder dieser Funktionseinheiten (FE1, FE2, ...) ein mindestens zwei Ausgänge aufweisender elektronischer Eingangsumschalter (EUS1, ...) zugeordnet ist, über den jeweils ein Eingangssignal (ES1, ES2, ...) über einen ersten Ausgang der Funktionseinheit (FE1, FE2, ...) oder über einen zweiten Ausgang der Kombinationseinheit (KOM) zugeführt wird, und den Funktionseinheiten (FE1, FE2, ...) ein mindestens zwei Eingänge aufweisender elektronischer Ausgangsumschalter (AUS1, ...) zugeordnet ist, über den jeweils über einen ersten Eingang ein Ausgangssignal (AS1, ...) der Funktionseinheit (FE1, ...) oder über einen zweiten Eingang ein Ersatz-Ausgangssignal (EAS) der Ersatz-Funktionseinheit (EFE) abgegeben wird,
die Kombinationseinheit (KOM) einen Kombinierer (KOB) aufweist, an dessen Eingänge (E1 bis E8) die zweiten Ausgänge der Eingangsumschalter geführt sind und dessen Ausgangssignal als Ersatz-Eingangssignal (EES) auf den Signaleingang der Ersatz-Funktionseinheit (EFE) geführt ist, der Kombinierer (KOB) mehrere Zweifach-Kombinierer (ZK) jeweils zum Durchschalten eines Eingangssignals enthält, wobei jeder Zweifach-Kombinierer (ZK) mit jeweils zwei Pin-Diodenschaltern (DK1, DK2,...) aufgebaut ist, bei dem jeweils gleiche Anschlüsse der Pin-Diodenschalter (DK1, DK2,...) zusammengeschaltet sind und dieser Verbindungspunkt über jeweils einen Entkopplungswiderstand (REK) auf einen gemeinsamen Zusammenführungspunkt für alle Zweifach-Kombinierer (ZK) geführt ist, und
die Kombinationseinheit (KOM) einen Verteiler (VER) aufweist, dem als Eingangssignal das von der Ersatz-Funktionseinheit (EFE) kommende Ersatz-Ausgangssignal (EAS) zugeführt ist und dessen Ausgänge (A1 bis A8) mit jeweils einem zweiten Eingang eines Ausgangsumschalters (AUS1, AUS2, ...) verbunden sind,
der Verteiler (VK2) mehrere Zweifach-Verteiler (ZV) zum Durchschalten des Ersatz-Ausgangssignals (EAS) von einem gemeinsamen Verzweigungspunkt auf einen der Ausgänge enthält, wobei jeder Zweifach-Verteiler (ZV) aus jeweils zwei mit gleichen Anschlüssen zusammengeschalteten PIN-Diodenschalter (DV1, DV2,...) aufgebaut ist und dieser Verbindungspunkt jeweils über einen gemeinsamen Entkopplungswiderstand (REV) den Verzweigungspunkt angeschaltet ist, und
alle Funktionseinheiten (FE1, FE2, ...) mit einer Steuerlogik (STL) verbunden sind, die aufgrund von Fehlermeldungen über die Eingangsumschalter (EUS1, EUS2, ...), die Kombinationseinheit und die Ausgangsumschalter (AUS1, AUS2, ...) eine defekte Funktionseinheit (FE1, ...) abtrennt und statt dieser die Ersatzfunktionseinheit (EFE) einfügt.

2. Ersatzschaltung nach Anspruch 1,
**dadurch gekennzeichnet,**
daß mindestens eine weitere Kombinationseinheit (KOM1, KOM2) und zwei Ersatz-Funktionseinheiten (EFE1, EFE2, ...) vorgesehen sind und
daß die Eingangsumschalter (EUS31, 32, ...) mindestens einen weiteren Ausgang und die Ausgangsumschalter (AUS 31, 32, ...) mindestens einen weiteren Eingang aufweisen und die weiteren Aus- und Eingänge der Umschalter (EUS31, 32, ...; AUS 31, 32, ...) mit der weiteren Kombinationseinheit (KOM2, ...) verbunden sind.

3. Ersatzschaltung nach einem der vorhergehenden Ansprüche,
**dadurch gekennzeichnet,**
daß die Funktionseinheiten (FE1, ...) eine Fehlerüberwachung aufweisen.

4. Ersatzschaltung nach einem der vorhergehenden Ansprüche,
**dadurch gekennzeichnet,**
daß auf der Kombinationseinheit (KOM) eine Steuerlogik (STL) vorgesehen ist, die die Fehlermeldungen auswertet und die Umschalter (EUS1, ... ;AUS1, ...) und die Kombinationseinheit (KOM) steuert.

5. Ersatzschaltung nach einem der vorhergehenden Ansprüche,
**dadurch gekennzeichnet,**
daß die Kombinationseinheit (KOM) Breitbandverstärker (V1, V2) aufweist, die die Dämpfung der Kombinierer/Verzweiger (VK1, VK2) ausgleichen.

6. Ersatzschaltung nach einem der vorhergehenden Ansprüche,
**dadurch gekennzeichnet,**
daß die Funktionseinheiten (FE1, ...) und elektronische Umschalter (EUS1, AUS1, ...) auf einer Baugruppe angeordnet sind.

7. Ersatzschaltung nach Anspruch 7,
**dadurch gekennzeichnet**,
daß die Eingangs- und Ausgangsumschalter (EUS1,,.. ;AUS1, ...) als PIN-Dioden-Umschalter (D1, D2, C, C1, C2, DR1, DR2, DR3) realisiert sind, bei denen an einer ersten PIN-Längsdiode (D1) eine konstante Steuerspannung (U1) anliegt und daß zum Umschalten nur die an der zweiten PIN-Längsdiode (D2) anliegende Steuerspannung (U2) variiert wird.

8. Ersatzschaltung nach Anspruch 7,
**dadurch gekennzeichnet,**
daß der PIN-Dioden-Umschalter (D1, D2) mit zusätzlichen einseitig an ein Bezugspotential geschaltete Querdioden (D11, D12) realisiert ist, daß die Steuerspannungen (U11, U12) den Längs- und den Querdioden (D1, D2, D11, D12) über Widerstände (R1, R2, R3, R4) zugeführt werden und daß der Verbindungspunkt der Längsdioden (D1, D2) über eine Drossel (DR3) an Masse liegt.

## Claims

1. Substitute circuit for a plurality of functional units (FE1, FE2, ...), in which
at least one combination unit (KOM) and one substitute functional unit (EFE), which is connected thereto, are assigned to a plurality of identical functional units (FE1, FE2, ...),
an electronic input changeover switch (EUS1, ...), which has at least two outputs, is assigned to each of these functional units (FE1, FE2, ...), via which electronic input changeover switch (EUS1) in each case one input signal (ES1, ES2, ...) is supplied, via a first output, to the functional unit (FE1, FE2, ...) or, via a second output, to the combination unit (KOM), and an electronic output changeover switch (AUS1, ...), which has at least two inputs, is assigned to the functional units (FE1, FE2, ...), via which electronic output changeover switch (AUS1, ...) in each case one output signal (AS1,...) from the functional unit (FE1, ...) is emitted, via a first input, or a substitute output signal (EAS) from the substitute functional unit (EFE) is emitted, via a second input,
the combination unit (KOM) has a combiner (KOB) to whose inputs (E1 to E8) the second outputs of the input changeover switch are passed, and whose output signal is passed as a substitute input signal (EES) to the signal input of the substitute functional unit (EFE), the combiner (KOB) contains a plurality of double combiners (ZK), each of which is intended to pass through an input signal, and with each double combiner (ZK) being formed by two pin diode switches (DK1, DK2, ...) in each case, in which equivalent connections of the pin diode switches (DK1, DK2, ...) are each interconnected, and this junction point is connected, via a decoupling resistor (REK) in each case, to a common interconnection point for all the double combiners (ZK), and
the combination unit (KOM) has a distributor (VER) to which the substitute output signal (EAS) coming from the substitute functional unit (EFE) is supplied as an input signal, and whose outputs (A1 to A8) are each connected to a second input of an output changeover switch (AUS1, AUS2, ...),
the distributor (VK2) contains a plurality of double distributors (ZV) for passing the substitute output signal (EAS) through from a common branching point to one of the outputs, with each double distributor (ZV) being formed from in each case two pin diode switches (DV1, DV2, ...) whose equivalent connections are interconnected, and this junction point in each case being connected via a common decoupling resistor (REV) to the branching point, and
all the functional units (FE1, FE2, ...) are connected to a control logic device (STL) which disconnects a defective functional unit (FE1, ...) on the basis of fault messages via the input changeover switches (EUS1, EUS2, ...), the combination unit and the output changeover switches (AUS1, AUS2, ...), and inserts the substitute functional unit (EFE) instead of said defective functional unit (FE1, ...).

2. Substitute circuit according to Claim 1, characterized in that at least one further combination unit (KOM1, KOM2) and two substitute functional units (EFE1, EFE2, ...) are provided, and
in that the input changeover switches (EUS31, 32, ...) have at least one further output and the output changeover switches (AUS 31, 32,...) have at least one further input, and the further outputs and inputs of the changeover switches (EUS31, 32, ...; AUS 31, 32, ...) are connected to the further combination unit (KOM2, ...).

3. Substitute circuit according to one of the preceding claims,
characterized
in that the functional units (FE1, ...) have fault monitoring.

4. Substitute circuit according to one of the preceding claims,
characterized
in that a control logic device (STL) is provided on the combination unit (KOM), evaluates the fault messages and controls the changeover switches (EUS1, ...; AUS1, ...) and the combination unit (KOM).

5. Substitute circuit according to one of the preceding claims,
characterized
in that the combination unit (KOM) has broadband amplifiers (V1, V2) which compensate for the attenuation of the combiners/splitters (VK1, VK2).

6. Substitute circuit according to one of the preceding claims,
characterized
in that the functional units (FE1, ...) and electronic changeover switches (EUS1, AUS1, ...) are arranged on an assembly.

7. Substitute circuit according to Claim 1,
characterized
in that the input and output changeover switches (EUS1, ...; AUS1, ...) are pin-diode changeover switches (D1, D2, C, C1, C2, DR1, DR2, DR3), in the case of which a constant control voltage (U1) is applied to a first pin series-path diode (D1), and in that only the control voltage (U2) which is applied to the second pin series-path diode (D2) is varied for switching over.

8. Substitute circuit according to Claim 7,
characterized
in that the pin-diode changeover switch (D1, D2) is formed by additional parallel-path diodes (D11, D12) which are connected to a reference-earth potential on one side, in that the control voltages (U11, U12) are supplied to the series-path diodes and to the parallel-path diodes (D1, D2, D11, D12) via resistors (R1, R2, R3, R4), and in that the junction point of the series-path diodes (D1, D2) is connected to earth via an inductor (DR3).

## Revendications

1. Circuit équivalent pour plusieurs unités fonctionnelles (FE1, FE2, ...), dans lequel
il est associé à plusieurs unités fonctionnelles identiques (FE1, FE2, ...) au moins une unité combinatoire (KOM) et une unité fonctionnelle équivalente (EFE) raccordée à celle-ci,
il est associé à chacune de ces unités fonctionnelles (FE1, FE2, ...) un commutateur d'entrée (EUS1, ...) électronique, qui comporte au moins deux sorties et par l'intermédiaire duquel respectivement un signal d'entrée (ES1, ES2, ...) est envoyé via une première sortie de l'unité fonctionnelle (FE1, FE2, ...) ou via une deuxième sortie de l'unité combinatoire (KOM), et il est associé aux unités fonctionnelles (FE1, FE2, ...) un commutateur de sortie (AUS1, ...) électronique, qui comporte au moins deux entrées et par l'intermédiaire duquel est délivré respectivement, via une première entrée, un signal de sortie (AS1, ...) de l'unité fonctionnelle (FE1, ...) ou, via une deuxième entrée, un signal de sortie équivalent (EAS) de l'unité fonctionnelle équivalente (EFE),
l'unité combinatoire (KOM) comporte un élément combinatoire (KOB) aux entrées (El à E8) duquel les deuxièmes sorties des commutateurs d'entrée sont conduites et dont le signal de sortie est conduit comme signal d'entrée équivalent (EES) sur l'entrée de signal de l'unité fonctionnelle équivalente (EFE), l'élément combinatoire (KOB) contient plusieurs doubles éléments combinatoires (ZK) à chaque fois pour la connexion d'un signal d'entrée, chaque double élément combinatoire (ZK) étant conçu à partir de deux interrupteurs à diodes PIN (DK1, DK2, ...) de telle sorte que, à chaque fois, des bornes identiques des interrupteurs à diodes PIN (DK1, DK2, ...) sont branchées ensemble et que ce point de jonction est conduit par l'intermédiaire d'une résistance de découplage (REK) à un point de rassemblement commun pour tous les doubles éléments combinatoires (ZK), et
l'unité combinatoire (KOM) comporte un élément distributeur (VER) auquel est envoyé comme signal d'entrée le signal de sortie équivalent (EAS) arrivant de l'unité fonctionnelle équivalente (EFE) et dont les sorties (A1 à A8) sont reliées à chaque fois à une deuxième entrée d'un commutateur de sortie (AUS1, AUS2, ...),
l'élément distributeur (VK2) contient plusieurs doubles éléments distributeurs (ZV) pour la connexion du signal de sortie équivalent (EAS) d'un point de ramification commun à l'une des sorties, chaque double élément distributeur (ZV) étant conçu à partir de deux interrupteurs à diodes PIN (DV1, DV2, ...) branchés ensemble par leurs bornes identiques et ce point de jonction étant raccordé à chaque fois par l'intermédiaire d'une résistance de découplage commune (REV) au point de ramification, et
toutes les unités fonctionnelles (FE1, FE2, ...) sont reliées à une logique de commande (STL) qui, sur la base de messages d'erreurs et par l'intermédiaire des commutateurs d'entrée (EUS1, EUS2, ...), de l'unité combinatoire et des commutateurs de sortie (AUS1, AUS2, ...), sépare une unité fonctionnelle défectueuse (FE1, ...) et insère à la place de celle-ci l'unité fonctionnelle équivalente (EFE).

2. Circuit équivalent selon la revendication 1, caractérisé par le fait que
il est prévu au moins une autre unité combinatoire (KOM1, KOM2) et deux unités fonctionnelles équivalentes (EFE1, EFE2, ...) et
les commutateurs d'entrée (EUS31, 32, ...) comportent au moins une autre sortie et les commutateurs de sortie (AUS31, 32, ...) comportent au moins une autre entrée et les autres sorties et entrées des commutateurs (EUS31, 32, ... ; AUS31, 32, ...) sont reliées à l'autre unité combinatoire (KOM2, ...).

3. Circuit équivalent selon l'une des revendications précédentes, caractérisé par le fait que
les unités fonctionnelles (FE1, ...) comportent un contrôle d'erreur.

4. Circuit équivalent selon l'une des revendications précédentes, caractérisé par le fait que
il est prévu sur l'unité combinatoire (KOM) une logique de commande (STL) qui évalue les messages d'erreurs et qui commande les commutateurs (EUS1, ... ; AUS1, ...) et l'unité combinatoire (KOM).

5. Circuit équivalent selon l'une des revendications précédentes, caractérisé par le fait que
l'unité combinatoire (KOM) comporte des amplificateurs à large bande (V1, V2) qui compensent l'amortissement des éléments combinatoires et distributeurs (VK1, VK2).

6. Circuit équivalent selon l'une des revendications précédentes, caractérisé par le fait que
les unités fonctionnelles (FE1, ...) et des commutateurs électroniques (EUS1, AUS1, ...) sont agencés sur un module.

7. Circuit équivalent selon l'une des revendications précédentes, caractérisé par le fait que
les commutateurs d'entrée, et de sortie (EUS1, ... ; AUS1, ...) sont mis en oeuvre sous forme de commutateurs à diodes PIN (D1, D2, C, C1, C2, DR1, DR2, DR3) selon lesquels une tension de commande constante (U1) est appliquée à une première diode PIN longitudinale (D1) et, pour la commutation, seule la tension de commande (U2) appliquée à la deuxième diode PIN longitudinale (D2) est modifiée.

8. Circuit équivalent selon la revendication 7, caractérisé par le fait que
le commutateur à diodes PIN (D1, D2) est mis en oeuvre avec des diodes transversales (D11, D12) supplémentaires branchées d'un côté à un potentiel de référence, les tensions de commande (U11, U12) sont envoyées aux diodes longitudinales et transversales (D1, D2, D11, D12) par l'intermédiaire de résistances (R1, R2, R3, R4) et le point de jonction des diodes longitudinales (D1, D2) est mis à la masse par l'intermédiaire d'une bobine (DR3).
